# EUROPÄISCHE PATENTSCHRIFT

(11) **EP 0 913 946 B1**
(45) Veröffentlichungstag und Bekanntmachung des Hinweises auf die Patenterteilung: **02.02.2005**
(21) Anmeldenummer: 98120249.2
(22) Anmeldetag: 26.10.1998
(51) Int. Cl.: H03L 7/07

(54) **Frequenzsynthesizer für ein Mobilfunkendgerät**
Frequency synthesiser for a mobile terminal
Synthétiseur de fréquence pour un terminal mobile

(30) Priorität: 29.10.1997 DE 19747735
(43) Veröffentlichungstag der Anmeldung: 06.05.1999
(73) Patentinhaber: Infineon Technologies AG, 81669 München (DE)
(72) Erfinder: Götz, Edmund, 85211 Dachau (DE); Feng, Shen Dr., San Diego, CA 92121 (US); Scholz, Markus, 81737 München (DE); Lipperer, Georg, 81735 München (DE); Beyer, Stefan, 86415 Mering (DE)
(74) Vertreter: Reinhard - Skuhra - Weise & Partner

(56) Entgegenhaltungen:
- GB-A- 2 188 804
- US-A- 4 191 930
- US-A- 4 785 260
- US-A- 5 420 545
- US-A- 5 610 559

## Beschreibung

Die Erfindung betrifft einen Frequenzsynthesizer mit einer Doppel-PLL-Anordnung, die jeweils im Rückkopplungszweig einen ersten Zähler bzw. einen zweiten Zähler zur wahlweisen Frequenzeinstellung aufweist.

Eine derartige Doppel-PLL-Anordnung (Phase Locked Loop) wird beispielsweise in der Mobilfunktechnik zur Frequenzsynthese in Mobilfunkgeräten eingesetzt. Die prinzipielle Anordnung der wesentlichen Elemente einer Doppel-PLL ist beispielsweise in dem Aufsatz von Wilfried Blaesner, Frequenzsynthesizer für Mobilfunk, Elektronik, 10/1998, Seiten 108 bis 112, insbesondere Bild 2, beschrieben. Dabei dient die eine PLL-Anordnung als Hochfrequenz-PLL, die nachfolgend als RF-PLL bezeichnet wird, und die andere als Zwischenfrequenz-PLL, die nachfolgend als IF-PLL bezeichnet wird. Mit der Doppel-PLL-Anordnung werden die unterschiedlichen Frequenzen zum Senden und Empfangen und zusätzlich die kanalabhängigen Frequenzen eingestellt. Dazu sind im Empfangsteil eine mit einem ersten lokalen Oszillator zusammenwirkende erste Mischstufe sowie eine mit einem zweiten lokalen Oszillator zusammenwirkende Mischstufe vorhanden.

Zur Verwendung in den unterschiedlichen Mobilfunksystemen sind die Mobilfunkendgeräte, die auch allgemein als Radioterminals (RT) bezeichnet werden, an die spezifischen Frequenzbereiche, der Mobilfunksysteme angepaßt, die als Band bezeichnet werden. Das heißt, der Frequenzsynthesizer eines Mobilfunkendgerätes des einen Mobilfunksystems erzeugt andere Frequenzen als der Frequenzsynthesizer eines anderen Mobilfunkendgerätes. Ferner unterscheiden sich bekannte Mobilfunksysteme noch in anderen Betriebsparametern, wie der Referenzfrequenz, Kanalfrequenz und ähnlichem. Ein Mobilfunkendgerät kann also nur innerhalb eines bestimmten Mobilfunksystems verwendet werden.

Ein weit verbreitetes Mobilfunksystem in Europa ist das GSM-System (Groupe Speciale Mobile; D1/D2-Netz), welches in einem Frequenzbereich von ca. 900 MHz betrieben wird. Ein anderes Mobilfunksystem im Frequenzbereich von ca. 1800 MHz ist unter der Bezeichnung DCS 1800 (Digital Cellular System 1800) in Betrieb. Es ist zwar bekannt, die GSM-Infrastruktur mit der DCS 1800-Infrastruktur zu kombinieren, was als Dual-Band bezeichnet wird, so daß ein insgesamt wirtschaftliches gemeinsames Netz aufgebaut werden kann. Trotzdem müssen für jeden Standard eigene Mobilfunkendgeräte verwendet werden.

Dies gilt umso mehr für Mobilfunksysteme, welche sich auch noch in anderen Betriebsparametern unterscheiden, wie beispielsweise den DECT-Standard für schnurlose Telefone. Sofern Systeme zum Beispiel für den DECT-Standard und einen anderen Standard einsetzbar sind, werden sie als Dualmode-Systeme bezeichnet.

Aus der US 4,191,930 ist ein Frequenzsynthesizer bekannt, der mehrere kaskadierte Oszillator-Stufen mit jeweils einem sogenannten phase-locked loop enthält. Die von den Oszillator-Stufen erzeugten Frequenzen können mittels Frequenzteiler verändert werden. Diese von den kaskadierten Oszillator-Stufen erzeugten Frequenzen werden einem gemeinsamen Ausgang-Oszillator zugeführt, der eine Ausgangsfrequenz liefert, die einer Last, z. B. einem Oszilloskop, zugeführt wird. Bei der Einstellung der Oszillator-Stufen, insbesondere beim Verstellen der auszugebenden Frequenz, kommt es zu kurzen Perioden der Instabilität, die sich bei mehreren kaskadierten Oszillator-Stufen zu signifikanten Störungen auswirken können. Dies soll verhindert werden, um eine stabile Ausgangsfrequenz auch bei einer Änderung der auszugebenden Frequenz zu liefern.

Aus der GB 2 188 804 A1 ist ein Frequenzsynthesizer bekannt, mit dem eine Vielzahl von Frequenzen in einem bestimmten Frequenzband für eine Radio- oder Fernsehanwendung erzeugt werden soll.

Der Erfindung liegt die Aufgabe zugrunde, ein Mobilfunkendgerät der eingangs genannten Art und einen Frequenzsynthesizer zur Verwendung in einem derartigen Mobilfunkendgerät anzugeben, welche in Mobilfunksystemen mit unterschiedlichen Netzfrequenzen und/oder anderen Betriebsparametern bei möglichst einfacher Handhabung eingesetzt werden können.

Diese Aufgabe wird durch einen Frequenzsynthesizer mit den Merkmalen der unabhängigen Patentansprüche 1 oder 6 gelöst. Bevorzugte Weiterbildungen sind in den jeweils davon abhängigen Patentansprüchen beschrieben.

Die Erfindung hat den Vorteil, daß abhängig von Steuerdaten, die von einer Basisstation ausgesendet werden, ohne Zutun des Benutzers automatisch eine Umschaltung in den Frequenzbereich oder die betreffenden Betriebsparameter des betreffenden Mobilfunksystems erfolgt. Der Benutzer kann daher das Mobilfunkendgerät als Dual-Band- oder Dual-Mode-Mobilfunkendgerät in gleicher Weise sowohl im Bereich des einen Mobilfunksystems als auch des anderen Mobilfunksystems benutzen, ohne daß er sich um eine Anpassung oder Umschaltung bemühen muß.

Ein Grundgedanke der Erfindung besteht demnach darin, daß von der Basisstation zur Grundinitialisierung die notwendigen Teilerwerte für die Frequenzteiler der Doppel-PLL an das Mobilfunkendgerät übermittel und dort abgespeichert werden. Im späteren Betrieb wird von der Basisstation grundsätzlich nur noch ein einziger Steuerwert in das Mobilfunkendgerät übermittelt, über welchen die Auswahl der abgespeicherten Teilerwerte und zusätzlich gegebenenfalls die Änderung und Umschaltung weiterer Betriebsparameter veranlaßt werden. Eine Änderung der Teilerwerte für den Hochfrequenzteil der Doppel-PLL (RF-PLL) verursacht durch eine entsprechende Verknüpfung mit den Frequenzteilern des Zwischenfrequenzteils der Doppel-PLL (IF-PLL) automatisch die zugehörige Änderung der Teilerwerte in der IF-PLL.

Die Abspeicherung der Teilerwerte erfolgt im einfachsten Fall in einzelnen Registern, die über einen Multiplexer unter Steuerung durch die Basisstation ausgewählt werden. Grundsätzlich ist aber jede andere Art von Speicher und Speicheransteuerung geeignet, um die erforderlichen Teilerwerte und logischen Verknüpfungen vorzunehmen.

Eine bevorzugte Ausführungsform der Erfindung zur Verwendung des Mobilfunkendgerätes im Dual-Band für das GSM-Mobilfunksystem und das DCS 1800-Mobilfunksystem besteht darin, daß drei Register zur Aufnahme unterschiedlicher Zählerwerte in den PLL-Zähler des Zwischenfrequenzteils eingebaut sind. Es können auf diese Weise drei Grundfrequenzen generiert werden, die ausreichen, um das Mobilfunkendgerät in beiden Mobilfunkstandards zu betreiben.

Zur Verwendung im Dual-Mode ist es besonders vorteilhaft, daß weitere Register zur Aufnahme unterschiedlicher Teilerwerte in der RF-PLL vorhanden sind, über welche die Referenzfrequenz (Kanalfrequenz) eines Mobilfunksystems, in der RF-PLL einstellbar ist, und daß über das Eingangsregister Schaltelemente ansteuerbar sind, über welche die systemspezifischen Betriebsparameter umschaltbar oder einstellbar sind.

Nachfolgend wird die Erfindung anhand von zwei in der Zeichnung dargestellten Ausführungsbeispielen weiter beschrieben.
- Fig. 1: zeigt schematisch einen Zeitrahmen des GSM- und DCS 1800-Standards;
- Fig. 2: zeigt anhand einer Tabelle die in einem Dual-Band zu generierenden Frequenzen;
- Fig. 3: zeigt schematisch anhand eines Blockschaltbildes einen Frequenzsynthesizer für ein Dual-Band-Mobilfunkendgerät; und
- Fig. 4: zeigt schematisch anhand eines Blockschaltbildes einen Frequenzsynthesizer für ein Dual-Mode-Mobilfunkendgerät.

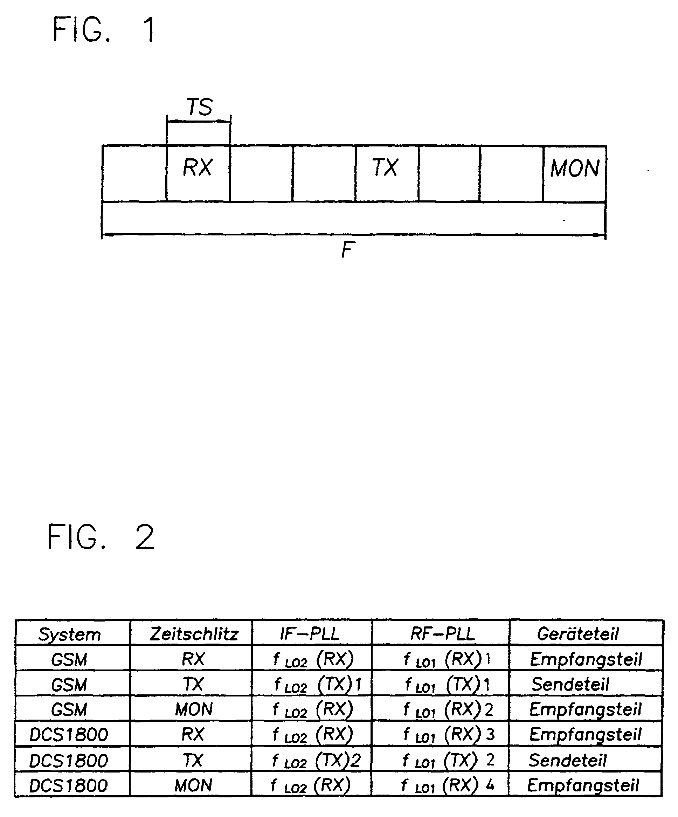

Gemäß Fig. 1 besteht ein Zeitrahmen F nach dem GSM- und DCS 1800-Standard aus acht Zeitschlitzen TS. Im dargestellten Beispiel ist der zweite Zeitschlitz RX für den Empfangsbetrieb des Mobilfunkendgerätes für Signale von der Basisstation vorgesehen. Der fünfte Zeitschlitz TX ist dem Sendebetrieb vorbehalten und der achte Zeitschlitz MON wird für den Monitor-Betrieb verwendet. Die im Sende- und Empfangsbetrieb verwendeten Frequenzen sind innerhalb eines Mobilfunksystems unterschiedlich. Außerdem sind die Frequenzen im Sendebetrieb nach dem GSM-Standard und nach dem DCS 1800-Standard unterschiedlich.

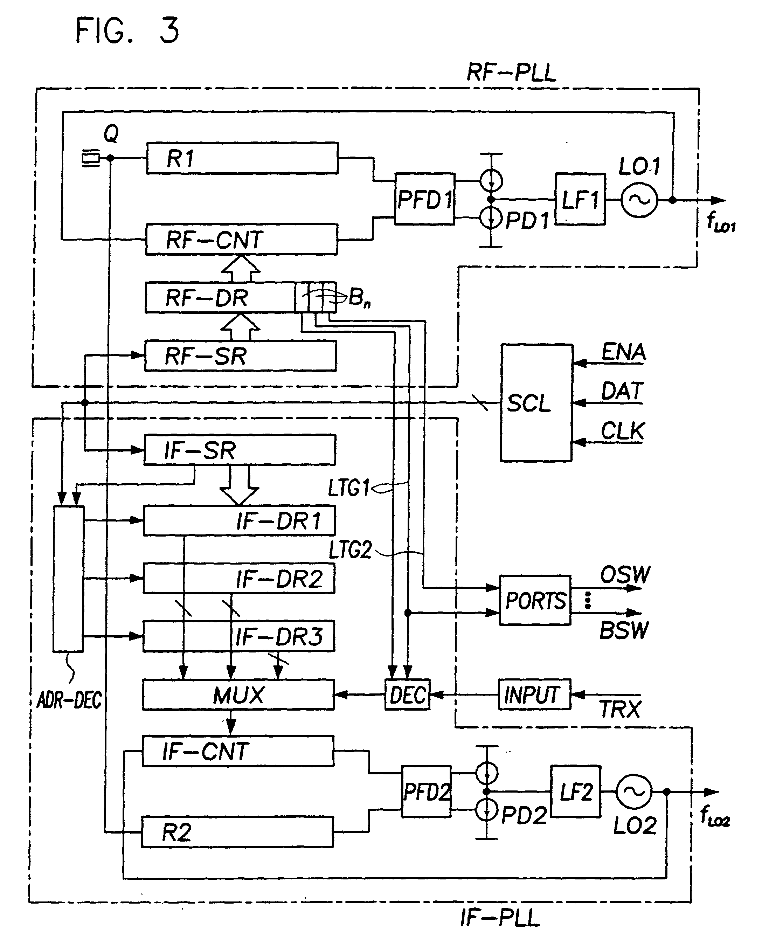

Wie die Tabelle gemäß Fig. 2 in Verbindung mit Fig. 3 zeigt, sind daher bei dem vorliegenden Beispiel in der PLL-Anordnung des Zwischenfrequenzteils IF-PLL drei unterschiedliche Frequenzen zu generieren, die für die Gerätearchitektur einmal festgelegt werden. Die Tabelle verdeutlicht ferner, daß bei Anwendungen für andere Mobilfunksysteme, auf die hier nicht näher eingegangen wird, grundsätzlich sechs verschiedene Frequenzen für die PLL-Anordnung des Hochfrequenzteils RF-PLL und sechs weitere Frequenzen für die PLL-Anordnung des Zwischenfrequenzbereichs IF-PLL erforderlich sein können.

In der ersten Spalte in Fig. 2 ist angegeben, um welches Mobilfunksystem und damit um welches Band es sich handelt. Die zweite Spalte enthält die zugehörigen Zeitschlitze RX, TX und MON. In der dritten und vierten Spalte sind die den einzelnen Zeitschlitzen zugeordneten, systembedingten Frequenzen der IF-PLL bzw. der RF-PLL angegeben. Die letzte Spalte verweist auf den zugehörigen Schaltungsteil des Mobilfunkendgerätes, in welchem die in der zugehörigen Zeile enthaltenen Frequenzen verwendet werden.

Bei dem hier beschriebenen Beispiel ist die Frequenz f_{LO1} der RF-PLL von den Zeitschlitzen und den Mobilfunksystemen abhängig und jeweils unterschiedlich. In der IF-PLL ist die Frequenz f_{LO1} (RX) im Zeitschlitz RX und MON des GSM-Standards sowie im Zeitschlitz RX und MON des DCS 1800-Standards gleich. Im Zeitschlitz TX des GSM-Standards wird eine hiervon unterschiedliche Frequenz f_{LO2} (TX)1 im GSM-Standard und eine dritte Frequenz f_{LO2} (TX)2 im TX-Zeitschlitz des DCS 1800-Standards verwendet. Der Frequenzsynthesizer des Mobilfunkendgerätes muß daher drei feste Zwischenfrequenzen generieren, die für die Gerätearchitektur einmal bei der Grundinitialisierung festgelegt werden.

Gemäß Fig. 3 werden nachfolgend auf den in Fig. 2 beschriebenen Gegebenheiten aufbauende Funktionen eines derartigen Frequenzsynthesizers beschrieben. Der Takt eines Quarzes Q wird über einen Zähler R1 einer PLL-Anordnung des Hochfrequenzteils (RF-PLL) zugeführt. Im Rückkopplungszweig der RF-PLL liegt ein einstellbarer Zähler RF-CNT, dessen Ausgang zusammen mit dem Ausgang des Teilers R1 einem Phasendetektor PFD1 zugeführt ist.
Dessen Ausgangssignal PD1 wird über einen Filter LF1 einem lokalen, spanungsgesteuerten Oszillator LO1 zugeführt, von dessen Ausgang die Frequenz f_{LO1} auf den Zähler RF-CNT zurückgeführt ist. In gleicher Weise liegt der Ausgang des Quarzes an einem weiteren Teiler R2 des Zwischenfrequenzteils IF-PLL an. In beiden Teilern R1, R2 wird der Quarztakt von beispielsweise 130 MHz auf eine für das betreffende Mobilfunknetz typische Kanalfrequenz f_{ch} von 200 kHz geteilt. Die Inhalte der Teiler R1, R2 bleiben während des gesamten Betriebs unverändert.

Im Rückkopplungszweig des Zwischenfrequenzteils IF-PLL liegt ein weiterer einstellbarer Zähler IF-CNT, der zusammen mit dem Teiler R2 an einem weiteren Phasendetektor TFD2 angeschlossen ist. Dessen Ausgangssignal PD2 liegt an einem weiteren Filter LF2 und einem weiteren lokalen, spannungsgesteuersten Oszillator LO2, dessen Frequenz f_{LO2} auf den weiteren Zähler IF-CNT zurückgekoppelt ist.

Um eine einfache Anpassung der Frequenz f_{LO2} der IF-PLL an die Frequenz f_{LO1} der RF-PLL zu erhalten, wenn von einem Mobilfunksystem auf das andere umgeschaltet wird, ist eine Grundinitialisierung durchzuführen, bei welcher die erforderlichen Teilerwerte für die IF-PLL abgespeichert werden. Im späteren Betrieb werden diese Teilerwerte dann zur Einstellung des Zählers IF-CNT der IF-PLL in Abhängigkeit von demjenigen Teilerwert verwendet, welcher in den Zähler RF-CNT der RF-PLL eingeschrieben wird, ohne daß der Benutzer des Gerätes aktiv werden muß. Das heißt mit anderen Worten, daß aufgrund von Betriebs- und Steuerdaten, die von einem mobilteilseitigen Basisbandprozessor (nicht dargestellt) generiert werden, die in Fig. 2 dargestellte Frequenzzuordnung automatisch durchgeführt wird. Diese Daten gelangen über einen Dreileitungsbus ENA, DAT, CLK über eine serielle Steuereinheit SCL jeweils in Speichereinrichtungen in der RF-PLL und der IF-PLL.

Diese Speichereinrichtungen bestehen in dem vorliegenden Beispiel bei der RF-PLL aus einem eingangsseitigen Schieberegister RF-SR, welchem ein Datenregister RF-DR nachgeschaltet ist, welches zur Datenübergabe an den Zähler RF-CNT dient. In der IF-PLL besteht die Speichereinrichtung aus einem eingangsseitigen Schieberegister IF-SR, welchem drei über einen Adressdecoder ADR-DEC ansteuerbare Datenregister IF-DR1, IF-DR2, IF-DR3 nachgeschaltet sind. Jeweils eines dieser Datenregister wird über einen Multiplexer MUX ausgewählt, um seinen Inhalt an den Zähler IF-CNT zu übergeben. Der Multiplexer MUX kann alternativ oder in Kombination auf zwei Weisen über einen Decoder DEC angesteuert werden. Dies kann einmal dadurch erfolgen, daß ein externes Signal TRX über einen Eingangsschaltkreis INPUT an den Decoder DEC angelegt wird. Bevorzugt wird es jedoch von der RF-PLL in der Weise angesteuert, daß vorgegebene Registerplätze Bₙ des Datenregisters RF-DR, welche vorgegebenen Bitstellen des Registerinhalts entsprechen, über Leitungen LTG1 mit dem Decoder DEC verbunden sind. Im Beispiel gemäß Fig. 3 handelt es sich um zwei höherwertige Bitstellen des Inhalts des Datenregisters RF-DR. Die höchstwertige Registerstelle ist in diesem Beispiel zur Auswahl einer Ausgangsschnittstelle PORTS vorgesehen, die zusammen mit einer zum Decoder DEC führenden Leitung LTG2 zur Auswahl von extern verfügbaren Steuersignalen OSW, BSW dient.

Die Ansteuerung des Decoders DEC erfolgt dabei über Steuerbits, die zusätzlich zum Teilerwert in das Datenregister RF-DR eingeschrieben werden. Daher weisen die betreffenden Register RF-SR und RF-DR entsprechend mehr Registerstellen auf als die Zahl der Bits der Teilerwerte.

Bei der Grundinitialisierung werden über die serielle Steuereinheit SCL die erforderlichen Teilerwerte für die IF-PLL in das Schieberegister IF-SR nacheinander eingeschrieben. Im vorliegenden Beispiel handelt es sich gemäß Fig. 2, Spalte 3 um drei Teilerwerte, die vom Schieberegister IF-SR in den drei Datenregistern IF-DR in Verbindung mit dem Adressdecoder ADR-DEC abgespeichert werden. Jedes der Schieberegister IF-DR enthält somit einen Teilerwert zur Erzeugung der Frequenzen f_{LO2}(RX), f_{LO2}(TX)1 sowie f_{LO2}(TX)2.

Im Betrieb wird für jeden Zeitschlitz RX, TX und MON die neue Frequenz f_{LO1} generiert, wie es in Spalte 4 von Fig. 2 wiedergegeben ist. Die hierfür in den Zähler RF-CNT einzuschreibenden Teilerwerte kommen in der vorstehend beschriebenen Weise von der seriellen Steuereinheit SCL. Wenn der betreffende Teilerwert vom Schieberegister RF-SR in das Datenregister RF-DR eingeschrieben ist, werden die zur Ansteuerung des Decoder DEC notwendigen Registerstellen aktiviert und es erfolgt automatisch die Durchschaltung des zugehörigen Datenregisters IF-DR über den Multiplexer MUX an den Zähler IF-CNT, so daß der für die IF-PLL erforderliche Teilerwert in den Zähler IF-CNT eingeschrieben wird. Das hat die gewünschte Änderung der Frequenz f_{LO2} der IF-PLL zur Folge. Wahlweise kann zur Decoderansteuerung noch das externe Signal TRX herangezogen werden.

Auf diese Weise erfolgt eine Kopplung zwischen der RF-PLL und der IF-PLL, mit welcher abhängig vom Inhalt des Datenregisters RF-DR der aktuell zutreffende Teilerwert in den Zähler IF-CNT
selbstätig eingeschrieben wird.

Die über den Ausgangsschaltkreis PORTS ausgewählten Signale OSW, BSW können dazu dienen, weitere Bauteile des betreffenden Gerätes auf die Parameter des jeweiligen Mobilfunksystems umzuschalten, wie beispielsweise Filter, Oszillatoren und ähnliches. Auch diese Umschaltung erfolgt dann automatisch in Abhängigkeit vom Inhalt der entsprechenden Registerstellen des Datenregisters RF-DR in der RF-PLL.

Wenn das betreffende Gerät beispielsweise zunächst im GSM-Standard arbeitet und man sich gerade im Zeitschlitz RX befindet, so wird über die serielle Steuereinheit SCL, das Schieberegister RF-SR und das Datenregister RF-DR ein Teilerwert eingeschrieben, welcher die Erzeugung der Frequenz f_{LO1}(RX)1 bewirkt. Gleichzeitig wird durch die entsprechenden Bits im Datenregister RF-DR über den Decoder DEC der Multiplexer MUX in der Weise angesteuert, daß der zur Generierung der Frequenz f_{LO1} (RX) erforderliche Teilerwert vom entsprechenden Datenregister IF-DR in den Zähler IF-CNT eingeschrieben wird. Wird dann beispielsweise in den DCS 1800-Standard und den Zeitschlitz TX umgeschaltet, so werden auf die gleiche Weise die erforderlichen Teilerwerte in die Zähler RF-CNT und IF-CNT eingeschrieben, um die Frequenzen f_{LO1}(TX)2 und f_{LO2}(TX)2 zu erzeugen.

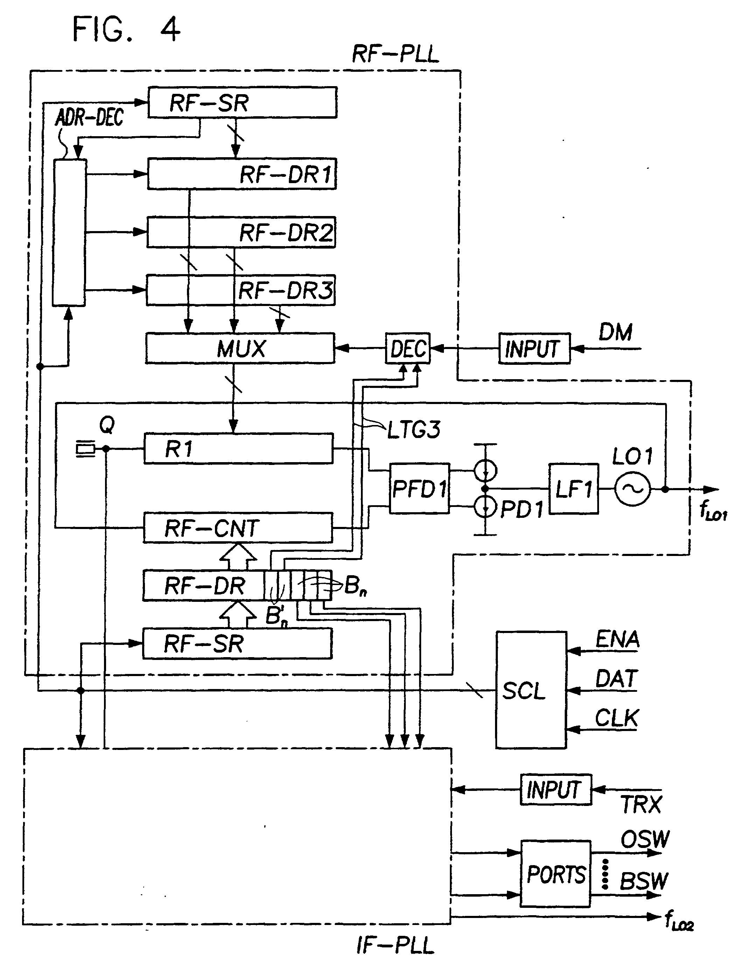

Bei dem Beispiel gemäß Figur 4 ist zusätzlich zu den beim Beispiel gemäß Fig. 3 beschriebenen Funktionen auch der Inhalt des Teilers R1 mittels abgespeicherter Teilerwerte veränderbar. Die Schaltung und Funktion der IF-PLL entspricht dabei unverändert dem Beispiel gemäß Fig. 3.

Die Umschaltung des Teilers R1 der RF-PLL erfolgt sinngemäß wie die im Zusammenhang mit Fig. 3 beschriebenen Umschaltung der IF-PLL. Es ist demnach ein Speicher vorgesehen, der bei einer Grundinitialisierung mit den erforderlichen Teilerwerten belegt wird. Im Betrieb wird jeweils einer der Teilerwerte ausgewählt und in den Teiler R1 eingeschrieben. Die Auswahl erfolgt wiederum automatisch unter Verwendung von vorgegebenen Registerstellen B'ₙ und/oder über ein externes Auswahlsignal DM.

Im folgenden Beispiel besteht die Speichereinrichtung aus einem eingangsseitigen Schieberegister RF-SR' sowie drei nachgeschalteten Datenregistern RF-DR, die über einen Adressdecoder ADR-DEC bei der Grundinitialisierung ausgewählt werden. Im Betrieb wird dann eines dieser drei Datenregister IF-DR über einen Multiplexer MUX mit dem Teiler R1 zum Einschreiben des entsprechenden Teilerwertes verbunden. Der Multiplexer MUX wiederum wird über einen Decoder DEC angesteuert, der eingangsseitig mit den entsprechenden Registerstellen B'ₙ des Datenregisters RF-DR und/oder mit einem Eingangsschaltkreis INPUT beaufschlagt wird. Auf diese Weise können für verschiedene Mobilfunknetze typische Kanalfrequenzen eingestellt werden. Wenn in dem vorliegenden Fall gemäß Fig. 4 , in dem drei Datenregister RF-DR1, RF-DR2, RF-DR3 angegeben sind, um drei verschiedene Kanalfrequenzen erzeugen zu können, so ist dies lediglich als Beispiel zu verstehen, welches im Bedarfsfall zur Erzeugung von weiteren unterschiedlichen Kanalfrequenzen durch entsprechende Änderung dieser Speichereinrichtung angepaßt werden kann.

## Patentansprüche

1. Frequenzsynthesizer für ein Mobilfunkendgerät mit einer ersten Phasenregelschleife (RF-PLL) zur Erzeugung eines Hochfrequenzsignals (f_{L01}) und einer zweiten Phasenregelschleife (IF-PLL) zur Erzeugung eines Zwischenfrequenzsignals (f_{L02}), wobei die erste und die zweite Phasenregelschleife einen ersten Frequenzteiler (RF-CNT) beziehungsweise einen zweiten Frequenzteiler (IF-CNT) aufweisen, denen das Hochfrequenzsignal (f_{L01}) beziehungsweise das Zwischenfrequenzsignal (f_{L02}) zugeführt ist, wobei die erste und die zweite Phasenregelschleife einen dritten Frequenzteiler (R1) beziehungsweise einen vierten Frequenzteiler (R2) aufweisen, denen jeweils ein Taktsignal einer Taktquelle (Q) zugeführt ist, und wobei die erste und die zweite Phasenregelschleife einen ersten Speicher (RF-DR, RF-SR) beziehungsweise einen zweiten Speicher (IF-DR1, IF-DR2, IF-DR3, IF-SR) aufweisen, die mit dem ersten Frequenzteiler (RF-CNT) beziehungsweise dem zweiten Frequenzteiler (IF-CNT) verbunden sind und in denen jeweilige Teilerwerte eintragbar sind,
**dadurch gekennzeichnet,**
**dass** der erste Speicher (RF-DR, RF-SR) und der zweite Speicher (IF-DR1, IF-DR2, IF-DR3, IF-SR) gekoppelt sind und in der zweiten Phasenregelschleife (IF-PLL) eine Auswahleinrichtung (MUX, DEC) vorgesehen ist, mit der der Teilerwert des zweiten Frequenzteilers (IF-CNT) festlegbar ist, wobei Registerplätze (Bₙ) eines Registers (RF-DR) des ersten Speichers (RF-DR, RF-SR) mit der Auswahleinrichtung (MUX, DEC) verbunden sind.

2. Frequenzsynthesizer nach Patentanspruch 1,
**dadurch gekennzeichnet,**
**dass** in der ersten Phasenregelschleife (RF-PLL) ein dritter Speicher (RF-DR1, RF-DR2, RF-DR3) vorgesehen ist, der mit dem dritten Frequenzteiler (R1) verbunden ist und in dem Teilerverhältnisse für den dritten Frequenzteiler (R1) eintragbar sind.

3. Frequenzsynthesizer nach Patentanspruch 2,
**dadurch gekennzeichnet,**
**dass** in der ersten Phasenregelschleife (RF-PLL) eine weitere Auswahleinrichtung (MUX, DEC, Fig. 4) vorgesehen ist, mit der das Teilerverhältnis des dritten Frequenzteilers (R1) festlegbar ist, wobei die weitere Auswahleinrichtung (MUX, DEC, Fig. 4) mit dem ersten Speicher (RF-DR, RF-SR) gekoppelt ist.

4. Frequenzsynthesizer nach Patentanspruch 3,
**dadurch gekennzeichnet,**
**dass** die Inhalte von Bitpositionen (Bn') eines Registers (RF-DR) in dem ersten Speicher (RF-DR, RF-SR) den Eingangsanschlüssen der Auswahleinrichtung (MUX, DEC, Fig. 4) zugeführt sind.

5. Frequenzsynthesizer nach einem der vorhergehenden Patentansprüche,
**dadurch gekennzeichnet,**
**dass** der erste Speicher (RF-DR, RF-SR) und der zweite Speicher (IF-DR1, IF-DR2, IF-DR3, IF-SR) jeweils ein Schieberegister (RF-SR, IF-SR) aufweisen, in die jeweilige Frequenzteilerdaten seriell einlesbar sind.

6. Frequenzsynthesizer für ein Mobilfunkendgerät mit einer Phasenregelschleife (RF-PLL) zur Erzeugung eines Hochfrequenzsignals (f_{L01}), wobei die Phasenregelschleife einen ersten Frequenzteiler (RF-CNT) aufweist, dem das Hochfrequenzsignal (f_{L01}) zugeführt ist, wobei die Phasenregelschleife einen zweiten Frequenzteiler (R1) aufweist, dem ein Taktsignal einer Taktquelle (Q) zugeführt ist, und wobei die Phasenregelschleife einen ersten Speicher (RF-DR, RF-SR) und einen zweiten Speicher (RF-DR1, RF-DR2, RF-DR3, RF-SR1) aufweist, die mit dem ersten Frequenzteiler (RF-CNT) beziehungsweise mit dem zweiten Frequenzteiler (R1) verbunden sind und in denen jeweilige Teilerwerte eintragbar sind,
**dadurch gekennzeichnet,**
**dass** der erste Speicher (RF-DR, RF-SR) und der zweite Speicher (RF-DR1, RF-DR2, RF-DR3, RF-SR') gekoppelt sind und in der Phasenregelschleife (RF-PLL) eine Auswahleinrichtung (MUX, DEC) vorgesehen ist, mit der der Teilerwert des zweiten Frequenzteilers (R1) festlegbar ist, wobei Registerplätze (Bn') eines Registers (RF-DR) des ersten Speichers (RF-DR, RF-SR) mit der Auswahleinrichtung (MUX, DEC) verbunden sind.

7. Frequenzsynthesizer nach Patentanspruch 6,
**dadurch gekennzeichnet,**
**dass** der erste Speicher (RF-DR, RF-SR) und der zweite Speicher (RF-DR1, RF-DR2, RF-DR3, RF-SR1) jeweils ein Schieberegister (RF-SR1, RF-SR) aufweisen, in die jeweilige Frequenzteilerdaten seriell einlesbar sind.

## Claims

1. Frequency synthesizer for a mobile radio terminal having a first phase locked loop (RF-PLL) for generating a radio-frequency signal (f_{LO1}) and a second phase locked loop (IF-PLL) for generating an intermediate-frequency signal (f_{LO2}), where the first and second phase locked loops have a first frequency divider (RF-CNT) and a second frequency divider (IF-CNT), respectively, which are supplied with the radio-frequency signal (f_{LO1}) and the intermediate-frequency signal (f_{LO2}), respectively, where the first and second phase locked loops have a third frequency divider (R1) and a fourth frequency divider (R2), respectively, which are respectively supplied with a clock signal from a clock source (Q), and where the first and second phase locked loops have a first memory (RF-DR, RF-SR) and a second memory (IF-DR1, IF-DR2, IF-DR3, IF-SR), respectively, which are connected to the first frequency divider (RF-CNT) and to the second frequency divider (IF-CNT), respectively, and can have respective division values entered in them, **characterized in that** the first memory (RF-DR, RF-SR) and the second memory (IF-DR1, IF-DR2, IF-DR3, IF-SR) are coupled and the second phase locked loop (IF-PLL) contains a selection device (MUX, DEC) which can be used to stipulate the division value of the second frequency divider (IF-CNT), with register locations (Bₙ) in a register (RF-DR) in the first memory (RF-DR, RF-SR) being connected to the selection device (MUX, DEC).

2. Frequency synthesizer according to Patent Claim 1, **characterized in that** the first phase locked loop (RF-PLL) contains a third memory (RF-DR1, RF-DR2, RF-DR3), which is connected to the third frequency divider (R1) and can have division ratios for the third frequency divider (R1) entered in it.

3. Frequency synthesizer according to Patent Claim 2, **characterized in that** the first phase locked loop (RF-PLL) contains a further selection device (MUX, DEC, Figure 4), which can be used to stipulate the division ratio of the third frequency divider (R1), with the further selection device (MUX, DEC, Figure 4) being coupled to the first memory (RF-DR, RF-SR).

4. Frequency synthesizer according to Patent Claim 3, **characterized in that** the contents of bit positions (Bn') in a register (RF-DR) in the first memory (RF-DR, RF-SR) are supplied to the input connections of the selection device (MUX, DEC, Figure 4).

5. Frequency synthesizer according to one of the preceding patent claims, **characterized in that** the first memory (RF-DR, RF-SR) and the second memory (IF-DR1, IF-DR2, IF-DR3, IF-SR) each have a shift register (RF-SR, IF-SR) to which respective frequency division data can be read serially.

6. Frequency synthesizer for a mobile radio terminal having a phase locked loop (RF-PLL) for generating a radio-frequency signal (f_{L01}), where the phase locked loop has a first frequency divider (RF-CNT) which is supplied with the radio-frequency signal (f_{L01}), where the phase locked loop has a second frequency divider (R1) which is supplied with a clock signal from a clock source (Q), and where the phase locked loop has a first memory (RF-DR, RF-SR) and a second memory (RF-DR1, RF-DR2, RF-DR3, RF-SR') which are connected to the first frequency divider (RF-CNT) and to the second frequency divider (R1), respectively, and can have respective division values entered in them, **characterized in that** the first memory (RF-DR, RF-SR) and the second memory (RF-DR1, RF-DR2, RF-DR3, RF-SR') are coupled and the phase locked loop (RF-PLL) contains a selection device (MUX, DEC) which can be used to stipulate the division value of the second frequency divider (R1), with register locations (Bn') in a register (RF-DR) in the first memory (RF-DR, RF-SR) being connected to the selection device (MUX, DEC).

7. Frequency synthesizer according to Patent Claim 6, **characterized in that** the first memory (RF-DR, RF-SR) and the second memory (RF-DR1, RF-DR2, RF-DR3, RF-SR1) each have a shift register (RF-SR1, RF-SR) to which respective frequency division data can be read serially.

## Revendications

1. Synthétiseur de fréquence pour un terminal de radiocommunication mobile avec une première boucle à verrouillage de phase (RF-PLL) pour produire un signal à haute fréquence (f_{L01}) et avec une deuxième boucle à verrouillage de phase (IF-PLL) pour produire un signal à fréquence intermédiaire (f_{L02}), la première et la deuxième boucle à verrouillage de phase comportant respectivement un premier diviseur de fréquence (RF-CNT) et un deuxième diviseur de fréquence (IF-CNT) auxquels sont envoyés respectivement le signal à haute fréquence (f_{L01}) et le signal à fréquence intermédiaire (f_{L02}), la première et la deuxième boucle à verrouillage de phase comportant respectivement un troisième diviseur de fréquence (R1) et un quatrième diviseur de fréquence (R2) auxquels est envoyé à chaque fois un signal d'horloge d'une source d'horloge (Q) et la première et la deuxième boucle à verrouillage de phase comportant respectivement une première mémoire (RF-DR, RF-SR) et une deuxième mémoire (IF-DR1, IF-DR2, IF-DR3, IF-SR) qui sont reliées respectivement au premier diviseur de fréquence (RF-CNT) et au deuxième diviseur de fréquence (IF-CNT) et dans lesquelles des valeurs de diviseur respectives peuvent être enregistrées,
**caractérisé en ce que** la première mémoire (RF-DR, RF-SR) et la deuxième mémoire (IF-DR1, IF-DR2, IF-DR3, IF-SR) sont couplées et **en ce qu'**il est prévu dans la deuxième boucle à verrouillage de phase (IF-PLL) un dispositif de sélection (MUX, DEC) avec lequel la valeur de diviseur du deuxième diviseur de fréquence (IF-CNT) peut être fixée, des places (Bₙ) d'un registre (RF-DR) de la première mémoire (RF-DR, RF-SR) étant reliées au dispositif de sélection (MUX, DEC).

2. Synthétiseur de fréquence selon la revendication 1,
**caractérisé en ce qu'**il est prévu dans la première boucle à verrouillage de phase (RF-PLL) une troisième mémoire (RF-DR1, RF-DR2, RF-DR3) qui est reliée au troisième diviseur de fréquence (R1) et dans laquelle des rapports de diviseur pour le troisième diviseur de fréquence (R1) peuvent être enregistrés.

3. Synthétiseur de fréquence selon la revendication 2,
**caractérisé en ce qu'**il est prévu dans la première boucle à verrouillage de phase (RF-PLL) un autre dispositif de sélection (MUX, DEC, figure 4) avec lequel le rapport du troisième diviseur de fréquence (R1) peut être fixé, l'autre dispositif de sélection (MUX, DEC, figure 4) étant couplé à la première mémoire (RF-DR, RF-SR).

4. Synthétiseur de fréquence selon la revendication 3,
**caractérisé en ce que** les contenus de positions binaires (Bn') d'un registre (RF-DR) dans la première mémoire (RF-DR, RF-SR) sont envoyés aux bornes d'entrée du dispositif de sélection (MUX, DEC, figure 4).

5. Synthétiseur de fréquence selon l'une des revendications précédentes,
**caractérisé en ce que** la première mémoire (RF-DR, RF-SR) et la deuxième mémoire (IF-DR1, IF-DR2, IF-DR3, IF-SR) comportent chacune un registre à décalage (RF-SR, IF-SR) dans lequel des données de diviseur de fréquence peuvent être enregistrées en série.

6. Synthétiseur de fréquence pour un terminal de radiocommunication mobile avec une boucle à verrouillage de phase (RF-PLL) pour produire un signal à haute fréquence (f_{L01}), la boucle à verrouillage de phase comportant un premier diviseur de fréquence (RF-CNT) auquel est envoyé le signal à haute fréquence (f_{L01}), la boucle à verrouillage de phase comportant un deuxième diviseur de fréquence (R1) auquel est envoyé un signal d'horloge d'une source d'horloge (Q) et la boucle à verrouillage de phase comportant une première mémoire (RF-DR, RF-SR) et une deuxième mémoire (RF-DR1, RF-DR2, RF-DR3, RF-SR') qui sont reliées respectivement au premier diviseur de fréquence (RF-CNT) et au deuxième diviseur de fréquence (R1) et dans lesquelles des valeurs de diviseur respectives peuvent être enregistrées,
**caractérisé en ce que** la première mémoire (RF-DR, RF-SR) et la deuxième mémoire (RF-DR1, RF-DR2, RF-DR3, RF-SR') sont couplées et **en ce qu'**il est prévu dans la boucle à verrouillage de phase (RF-PLL) un dispositif de sélection (MUX, DEC) avec lequel la valeur de diviseur du deuxième diviseur de fréquence (R1) peut être fixée, des places (Bn') d'un registre (RF-DR) de la première mémoire (RF-DR, RF-SR) étant reliées au dispositif de sélection (MUX, DEC).

7. Synthétiseur de fréquence selon la revendication 6, **caractérisé en ce que** la première mémoire (RF-DR, RF-SR) et la deuxième mémoire (RF-DR1, RF-DR2, RF-DR3, RF-SR1) comportent chacune un registre à décalage (RF-SR1, RF-SR) dans lequel des données de diviseur de fréquence respectives peuvent être enregistrées en série.
